# EUROPEAN PATENT SPECIFICATION

(11) **EP 2 100 376 B1**
(45) Date of publication and mention of the grant of the patent: **10.01.2018**
(21) Application number: 08713720.4
(22) Date of filing: 11.01.2008
(51) Int. Cl.: H03K 3/38

(54) **SINGLE FLUX QUANTUM CIRCUITS**
SINGLE FLUX QUANTUM SCHALTUNG
CIRCUITS QUANTIQUES À FLUX UNIQUE

(30) Priority: 18.01.2007 US 654632; 13.12.2007 US 956293
(43) Date of publication of application: 16.09.2009
(73) Proprietor: Northrop Grumman Systems Corporation, Los Angeles, CA 90067-2199 (US)
(72) Inventor: HERR, Quentin P., Ellicott City, Maryland 21042 (US)
(74) Representative: Viering, Jentschura & Partner mbB Patent- und Rechtsanwälte
(86) International application number: PCT/US2008/050864
(87) International publication number: WO 2008/089067

(56) References cited:
- EP-A- 0 467 104
- US-A- 5 309 038
- US-A1- 2003 016 069

## Description

### Field of the Invention

This invention, in general, relates to superconductor circuits and, more particularly, to superconductor circuits which utilize superconducting Josephson junctions.

In the field of digital logic extensive use is made of well known and highly developed CMOS (complimentary metal-oxide semiconductor) technology. As CMOS has begun to approach maturity as a technology, there is an interest in alternatives that may lead to higher performance in terms of speed, power dissipation computational density, interconnect bandwidth, and the like.

An alternative to CMOS technology comprises superconductor based single flux quantum circuitry, utilizing superconducting Josephson junctions, with typical signal power of around 4 nW (nanowatts), at a typical, data rate of 20 Gb/ s (gigabytes/ second), or greater, and operating temperatures of around 4° Kelvin.

As will be subsequently described, the Josephson junction is an active device supplied with a DC bias and the power budget in such circuits is dominated by static power consumption which happens whether or not the active device is switching. It would be desirable to reduce power consumption including elimination of static power dissipation in such circuits.

From the United States patent US 5,309,038 a superconducting toggle flip - flop circuit according to the pre-characterizing part of claim 1 is known.

Accordingly, it is an object of the present invention to reduce or eliminate unnecessary power dissipation in single flux quantum Josephson junction circuits while reducing the number of required Josephson junctions.

This and other objects are achieved by the features in the characterizing part of claim 1 in conjunction with the features in the pre-characterizing part of claim 1. Advantageous further embodiments are claimed in the dependent claims 2 - 7.

This and other objects of the present invention are provided by a superconducting single flux quantum circuit comprising at least one Josephson junction which is provided with an input pulse and which flips and provides an output pulse when the current through the Josephson junction exceeds a critical value. The circuit is completely devoid of any resistors that would provide a bias current to the Josephson junction.

Further scope of applicability of the present invention will become apparent from the detailed description provided hereinafter. It should be understood, however, that the detailed description and specific example, while disclosing the preferred embodiment of the invention, is provided by way of illustration only.

### Brief Description of the Drawings

The present invention will become more fully understood from the detailed description provided hereinafter and the accompanying drawings, which are not necessarily to scale, and are given by way of illustration only, and wherein:
Figure 1 is a diagram of a prior art single flux quantum Josephson junction circuit.
Figure 1A is illustrative of waveforms associated with the circuit of Figure 1.
Figure 2 is an example of a diagram illustrating an example biasing arrangement.
Figure 2A illustrates example waveforms associated with the example circuit of Figure 2.
Figure 3 illustrates another embodiment of the present invention.
Figure 3A illustrates waveforms associated with the circuit of Figure 3.
Figure 4 is a diagram illustrative of a prior art single flux quantum Josephson junction Exclusive OR (XOR) gate.
Figure 5 is an example of a diagram illustrating an example for an Exclusive OR gate.
Figure 5A illustrates example waveforms associated with the example circuit of Figure 5.
Figure 6 is diagram illustrating still another embodiment of an Exclusive OR gate in accordance with the present invention.
Figure 6A depicts waveforms associated with the circuit of Figure 6.
Figure 7 is diagram illustrating yet another embodiment of an Exclusive OR gate in accordance with the present invention.
Figure 7A illustrates waveforms associated with the circuit of Figure 3.
Figure 8 illustrates an AND gate in accordance with the present invention.
Figure 9 illustrates an OR gate in accordance with the present invention.

### Description of the Preferred Embodiment

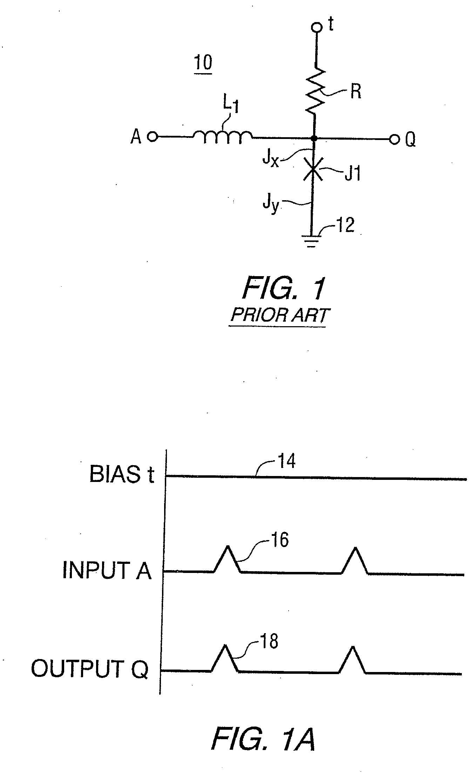

Referring now to Figure 1, there is shown a superconducting circuit 10 having a single Josephson junction J1 designated by the symbol "X" and having first and second terminals Jₓ and J_{y}, as do all of the Josephson junctions described herein. Basically, a Josephson junction is comprised of two layers of superconductors separated by a very thin layer of an insulator. When cooled to superconducting temperatures and biased with a DC current below a certain critical current I_{c}, the Josephson junction is superconducting and conducts current without developing a voltage drop and exhibiting substantially no electrical resistance.

When an input voltage pulse, called a single flux quantum pulse, derived from a previous superconducting circuit is applied, sufficient bias current is supplied to attain the critical current. At this point the Josephson junction triggers, or "flips" and generates a single flux quantum output pulse in response to the single flux quantum input pulse. Such circuits may be used to feed a plurality of subsequent circuits or for impedance matching purposes.

In Figure 1, a DC bias current is supplied to Josephson junction J1 via terminal t through resistor R flows to ground 12. This DC bias current is depicted by waveform 14 of Figure 1A. An input A pulse 16, in Figure 1A, is applied to input terminal A of Figure 1 and through inductor L₁. When the critical current I_{c} through Josephson junction J1 is attained, an output pulse 18 is generated at output terminal Q. The DC current through resistor R represents an unwanted static power dissipation which generates objectionable heat. In order to compensate for this heat, additional cooling requirements must be applied to the superconducting circuit.

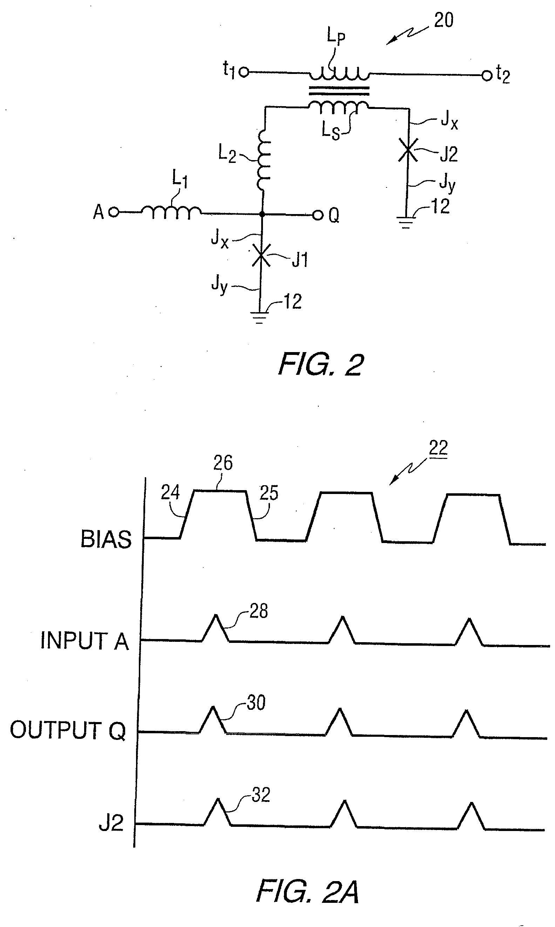

Figure 2 illustrates an example biasing arrangement which completely eliminates the requirement for the heat dissipating resistor R of Figure 1. The circuit of Figure 2 includes, similar to Figure 1, a Josephson junction J1 is directly connected to ground 12 via J_{y}. The circuit similarly includes input terminal A connected to Josephson junction J1 through a first inductor L₁, defining an input inductor. The circuit also includes an output terminal Q.

The circuit of Figure 2 presents a biasing arrangement devoid of any resistors and which includes a superconducting biasing transformer 20 having primary and secondary windings L_{P} and L_{S}. An AC bias current, as depicted by waveform 22 of Figure 2A, is applied across terminals t₁ and t₂ of transformer 20. By way of example, the AC bias current waveform 22 is a trapezoidal waveform which includes a leading edge 24, a trailing edge 25, with the two being joined by a horizontal portion 26. Bias current from secondary winding Ls is supplied to Josephson junction J1 through a second inductor L₂. Current also travels up from ground 12 through a second Josephson junction J2, but at a current value less than its critical current.

Some time during the application of horizontal portion 26 of waveform 22, an input voltage pulse 28, Figure 2A, is applied to input terminal A. When the critical current I_{C} is attained, Josephson junction J1 flips and an output pulse 30 is generated at output terminal Q. This flipping action also causes a current to travel up through inductor L₂, and through inductor L_{S} and Josephson junction J2. This reverse current through Josephson junction J1 would normally prevent its resetting and subsequent flipping. This however is obviated by the arrangement of Figure 2. More particularly, when bias current is on the trailing edge 25 of waveform 22, this along with the reverse current through Josephson junction J2 causes Josephson junction J2 to flip, providing output pulse 32, shown in Figure 2A, thus sending current back in the other direction to effectively cancel the current due to the flipping of J1. Thus, the circuit is ready for the next input pulse.

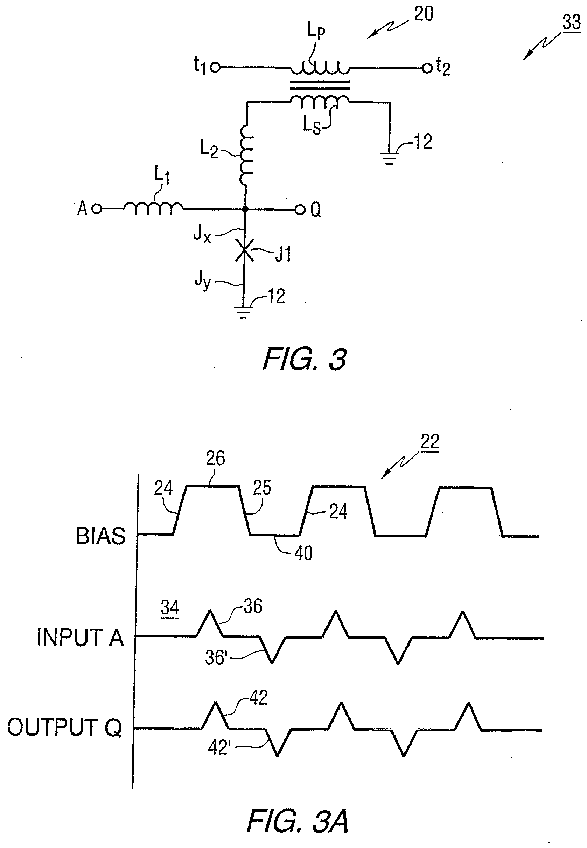

A single flux quantum output pulse similar to that provided by the circuit of Figure 2 may be realized with the circuit 33 of Figure 3, however, with one less Josephson junction. This is accomplished with the provision of input pulse waveform 34 shown in Figure 3A. The input pulse 34 waveform includes a positive portion 36 which occurs during the upper horizontal portion 26 of waveform 22, followed by a negative portion 36' which occurs during the lower horizontal portion 40 of waveform 22.

When Josephson junction J1 flips, it generates a positive output pulse 42 sending current through inductor L₂ and winding L_{S} to ground 12. Negative input pulse 36' causes Josephson junction J1 to flip in an opposite direction to cancel such current allowing it to reset for the next applied pulse and causing a negative output pulse 42' to be generated.

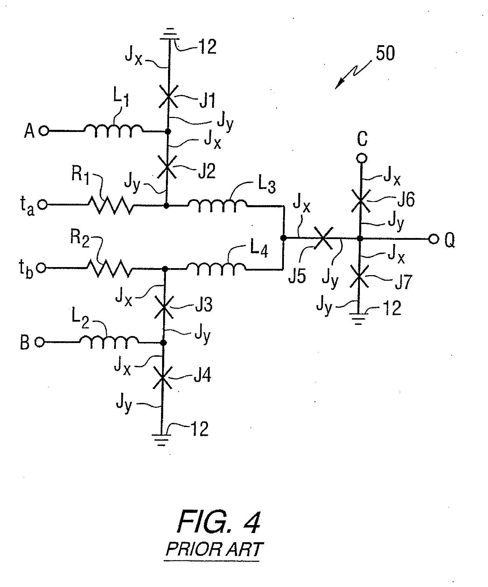

An Exclusive OR gate is a binary logic gate which will produce an output if one and only one input is present. For example, for a two input Exclusive OR gate, a binary output will be provided only if the two inputs are different. Figure 4 is illustrative of a prior art Exclusive OR gate 50 implemented with superconducting Josephson junctions. In addition to seven Josephson junctions J1 to J7, the circuit includes four inductors L₁ to L₄ and two biasing resistors R₁ and R₂. An input at terminal A or B will result in an output at terminal Q. Such a circuit suffers the same deficiencies as that of Figure 1 in that there is a wasteful dissipation of power due to the resistors R₁ and R₂.

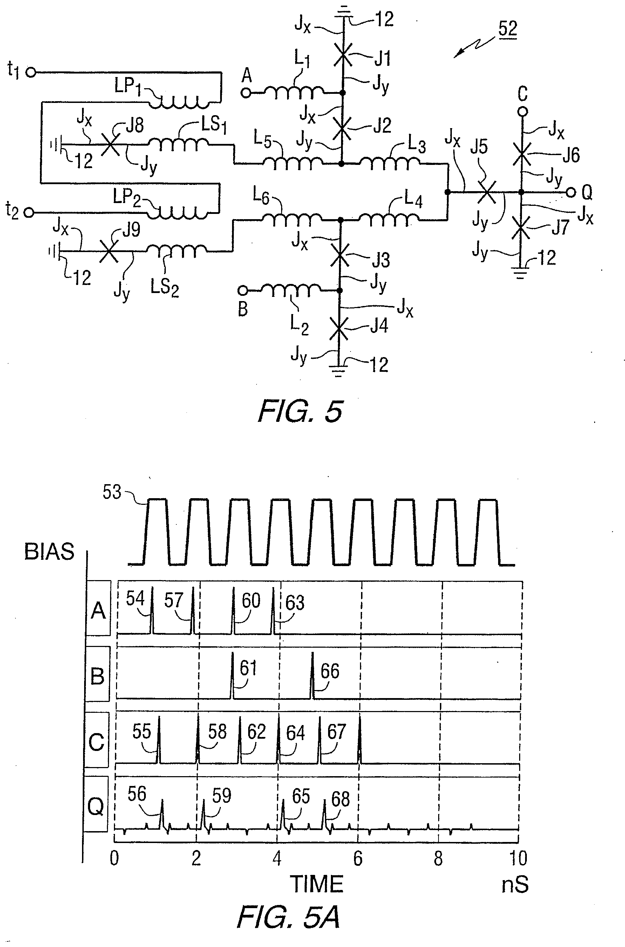

Figure 5 illustrates an Exclusive OR gate 52 which eliminates the problem. In Figure 5, the bias resistors R₁ and R₂ of Figure 4 are replaced by a two transformer biasing arrangement which includes a first primary winding L_{P1}, a first secondary winding L_{S1}, a second primary winding L_{P2}, and a second secondary winding L_{S2}. An AC bias current designated by numeral 53 is shown in Figure 5A, is applied across terminals t₁ and t₂. The circuit also includes a pair of coupling inductors L₅ and L₆. The remainder of the circuit is the same as Figure 4.

When the bias current 53 is high, current travels through inductor L₅ by transformer action and through Josephson junctions J2 and J1 to ground via Jₓ of J1. Let it be assumed that an input A, pulse 54, shown in Figure 5A, is now applied. The combination of bias current and input current flips Josephson junction J1, the result of which is to drive current down through Josephson junction J2, through inductor L₃ and through Josephson junctions J5 and J7 to ground via J_{y} of J7. When clock pulse 55, shown in Figure 5A, is applied at input C, the critical current in Josephson junction J7 is exceeded and it flips, resulting in a Q output pulse 56.

The flipping of Josephson junction J7 steers current back through Josephson junction J5 and inductor L₄ which causes Josephson junction J3 to exceed its critical current. When Josephson junction J3 flips, it reverses the current, preventing current from flowing out the B input. Finally, when Josephson junction J1 flipped, it also sent current back through inductor L₅ as well as Josephson junction J8, flipping it, thereby pushing current back through inductors L_{S1} and L₅ to cancel the current and to reset the circuit.

In the scenario shown in Figure 5A, the next pulse is also an A pulse 57 and the operation just described applies such that when a subsequent clock pulse 58 is applied, an output Q pulse 59 occurs.

The next pulses are the simultaneous provision, or provision in the same cycle, of both an A pulse 60 and B pulse 61. Along with the bias current through Josephson junctions J2 and Josephson junction J3, input pulse 60 causes Josephson junction J1 to flip, sending current through inductor L₃ and Josephson junction J5. Similarly, the combination of bias current and input pulse B causes Josephson junction J4 to flip and send current through inductor L₄ and Josephson junction J5. The two currents through Josephson junction J5 exceed its critical current and cause it to flip canceling out the currents through L₃ and L₄ such that when clock pulse 62 is provided, Josephson junction J7 has insufficient current to flip it, and thus no output pulse Q is provided.

When Josephson junctions J1 and J4 flipped, they also sent current back through inductors L₅ and L₆ as well as Josephson junctions J8 and J9. On the downward slope of waveform 53, current is added to Josephson junctions J8 and J9, flipping them, thereby pushing current back through inductors L_{S1} and L₅ and L_{S2} and L₆ to cancel the current to reset the circuit.

The next scenario of Figure 5A is the provision of only a B pulse 66. When the B pulse 63 is provided, it along with bias current through inductor L₆ and Josephson junction J3 causes Josephson junction J4 to flip, sending current up through Josephson junction j3, inductor L₄, Josephson junction J5 and down through Josephson junction J7. When clock pulse 67 is applied, it is sufficient to flip Josephson junction J7 to provide the Q output 68.

When Josephson junction J7 flips it also steers current back through Josephson junction J5, inductor L₃ and Josephson junction J2, which flips to reverse the current and prevent current from coming out the A input. Finally, when Josephson junction J4 flipped, it also sent current back through inductor L₆ as well as Josephson junction J9, flipping it, thereby pushing current back through inductors L_{S2} and L₆ to cancel the current to reset the circuit.

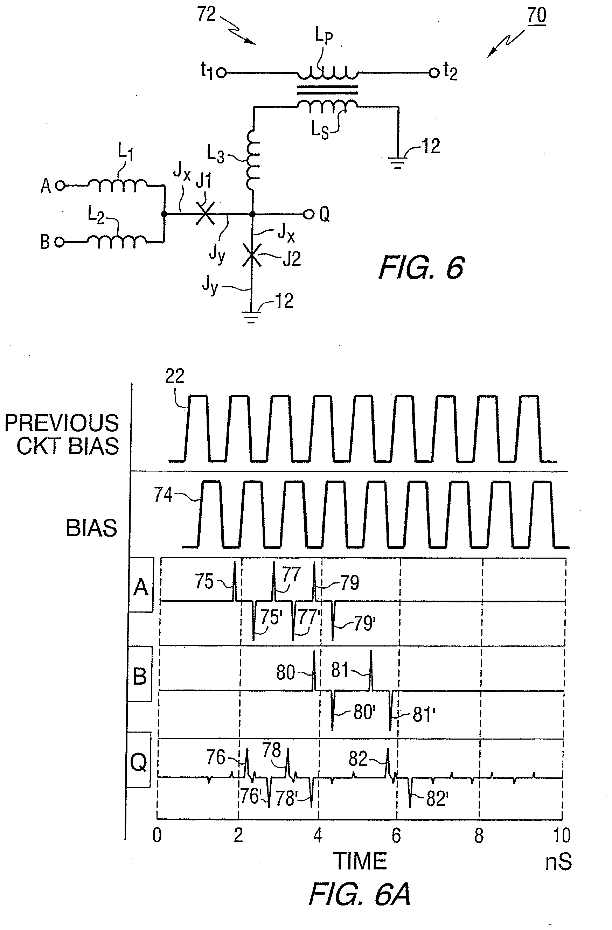

Referring now to Figure 6, illustrated is another Exclusive OR gate 70 and one which eliminates the need for an explicit clock and further reduces the number of Josephson junctions required. The circuit includes a biasing transformer 72 having a primary winding L_{P} and a secondary winding L_{S} which provides bias current 74 shown in Figure 6A through inductor L₃ and Josephson junction J2. Input A is coupled to Josephson junction J2 via a first input inductor L₁ and Josephson junction J1, and input B is coupled to Josephson junction J2 via a second input inductor L₂ and Josephson junction J1.

Inputs A and B are supplied by respective prior circuits, each as shown in Figure 3, and bias waveform 22 in Figure 6A is the waveform applied to those prior circuits.

With an A input 75 occurring prior to the rising edge of waveform 74, current flows through inductor L₁, Josephson junction J1 and through Josephson junction J2. When the applied bias current is of sufficient value, Josephson junction J2 will flip resulting in a Q output 76. As before, current through L₃ and L_{S} is counteracted by the negative portion 75' of the input pulse. Figure 6A also illustrates a second A pulse 77 resulting in a Q output 78.

A third A pulse 79 in Figure 6A occurs simultaneously with, or in the same cycle as a B pulse 80. In such a case, Josephson junction J1 has sufficient current to flip and since Q will still be grounded through Josephson junction J2, no output will occur and the flipping action of Josephson junction J1 will cancel out the input currents.

The scenario of Figure 6A also shows an input B pulse 81. The operation is similar to an A pulse in that Josephson junction J2 will flip when supplied with sufficient bias current, resulting in a Q output 82. Resetting will occur with the negative portion 81' of the B input pulse.

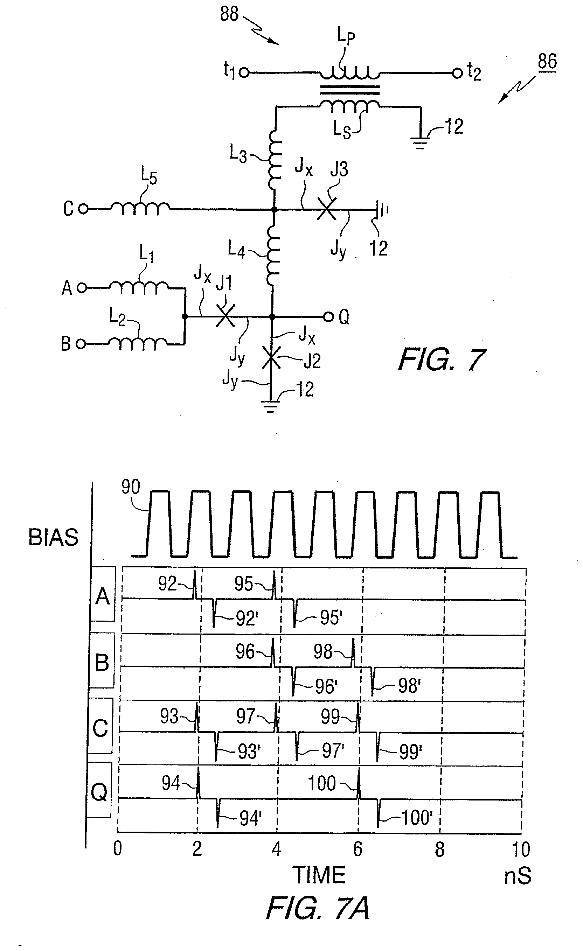

Referring now to Figure 7, shown thereat is another Exclusive OR gate 86, having a bias transformer 88 with primary and secondary windings L_{P} and L_{S}. The phasing of two different waveforms is not needed as in Figure 6A since the circuit of Figure 7 includes a provision for a clock pulse at C. Inputs A and B are coupled to Josephson junctions J1 and J2 through respective first and second input inductors L₁ and L₂. Third and fourth inductors L₃ and L₄ connect L_{S} with Josephson junction J2 and a clock pulse at C is applied through input inductor L₅ to Josephson junction J3.

As shown in Figure 7A, the bias waveform is designated by numeral 90. When waveform 90 is high, an A pulse 92, when applied, sends current through Josephson junction J2, but not enough to flip it. Bias current is directed through inductor L₃ and Josephson junction J3 to ground. When clocking pulse 93 is applied at C, the predominance of current goes through Josephson junction J3 to cause it to flip. When this happens, Josephson junction J3 sends current down through inductor L₄ and Josephson junction J2 causing it to flip and produce a Q output 94 and send current back up through inductor L₄ and Josephson junction J3. The negative portion 92' of the input pulse resets the circuit for the next pulse, as previously described.

The scenario continues with both an A pulse 95 and B pulse 96 being provided simultaneously or in the same cycle. When this occurs, Josephson junction J1 has sufficient current to flip which deprives Josephson junction J2 of the necessary current to flip such that no output signal is generated.

Then next pulse shown is a B pulse 98 which, when clock pulse 99 is provided, will cause an output pulse 100 in a similar manner previously described with respect to the provision of an A pulse.

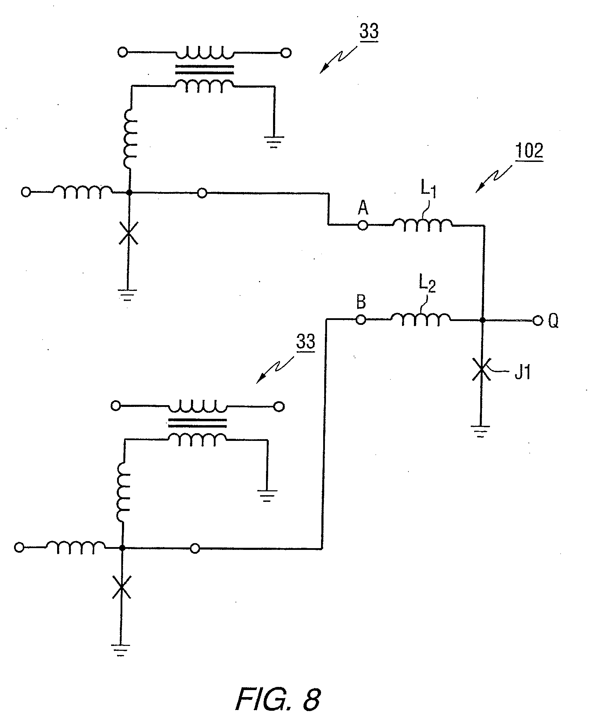

Next, an AND gate is a circuit which will provide an output only if all of its inputs are present. Figure 8 illustrates a two input AND gate 102 in accordance with the principles of the present invention. As shown, AND gate 102 includes a Josephson junction J1 which will provide an output pulse at Q when it flips. First and second inputs A and B are connected to Josephson junction J1 through respective first and second input inductors L₁ and L₂. The A and B inputs are derived from respective circuits 33, previously described with respect to Figure 3. If there is only one input, due to the superconducting nature of the circuit, the input is stored as a persistent current flowing through L₁ (or L₂) to ground, which is not sufficient to flip J1 so that there is no output. The circuit is then reset by the negative half cycle of the input pulse.

When both inputs A and B are present, and only when both are present, the current through Josephson junction J1 exceeds the critical current such that Josephson junction J1 will flip, providing an output signal indicative of an AND state.

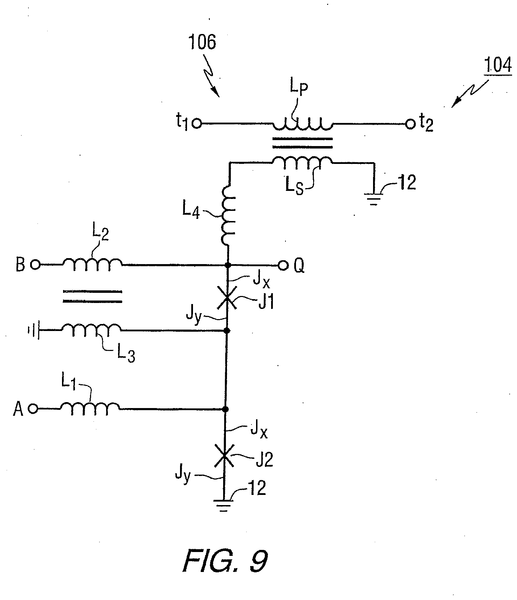

Referring now to Figure 9, an OR gate is a circuit which will provide an output if any or all of its inputs are present. Figure 9 is illustrative of a two input OR gate 104 in accordance with the principles of the present invention. The OR gate 104 includes biasing transformer 106 having primary and secondary windings L_{P} and L_{S}, with winding L_{S} being connected in series with inductor L₄, and Josephson junctions J1 and J2.

The A input is coupled to Josephson junction J2 by a first input inductor L₁ while the B input is coupled to Josephson junction J1 by a second input inductor L₂, where the inductance of L₂ is much greater than the inductance of L₁. An inductor L₃ is in a mutually coupled arrangement with inductor L₂ and has a comparable inductance value. An output Q is connected to Josephson junction J1.

With a bias current established through Josephson junction J2, an input A pulse will flip it resulting in a Q output. When Josephson junction J2 flips it sends current up through Josephson junction J1, inductor L₄ and secondary winding L_{S} to ground. Current also flows back through inductors L₂ and L₃ in the same direction but since the inductor values are so high, this current is very low and has no effect on prior circuits. A negative cycle of the input A pulse will reset the circuit, as previously explained.

When a B pulse is applied, current in L₂ induces current in L₃ in an opposite direction. Even though the inductances of L₂ and L₃ are large, the total loop inductance is small and similar in value to the inductance of inductor L₁. This allows the B pulse to flip Josephson junction J1, which already has bias current. When Josephson junction J1 flips an output is provided at Q and current is sent up through inductor L₄ and secondary winding L_{S} to ground. The subsequent negative portion of the B pulse will reset the circuit.

If both an A and B pulse are present, both Josephson junctions J1 and J2 flip, as previously explained. In such instance the output pulse at Q will be twice the size of a normal output pulse since the pulses caused by Josephson junctions J1 and J2 add. Since it is desired to have all pulses of uniform value, this may be rectified by feeding the output pulse to a subsequent circuit such as described in Figure 3, which will then convert the double sized pulse to a normal sized one.

## Claims

1. A superconducting single flux quantum circuit, comprising:
at least one Josephson junction (J₁) for receiving an input pulse (A), said Josephson junction (J₁) being configured to flip when the current through said Josephson junction (J₁) exceeds a critical value; and
a bias transformer (20) for receiving an AC waveform (22), said bias transformer having a primary winding (L_{P}) and a secondary winding (L_{S}), said secondary winding being connected to said Josephson junction (J₁) for supplying a bias current thereto derived from said waveform;
**characterized by**
said input pulse (A) having a positive portion (36, 75, 92) followed by a negative portion (36', 75', 92') and the circuit being configured such that said negative portion (36', 75', 92') of said input pulse (A) resets the circuit for a subsequent input pulse.

2. The circuit according to claim 1, further comprising:
at least one input (A) for supplying the input pulse (A) through a first inductor (L₁) to said Josephson junction (J₁); and
an output (Q) for deriving an output pulse from said Josephson junction.

3. The circuit according to claim 2, wherein said AC waveform (22) defines a trapezoidal waveform.

4. The circuit according to claim 2, wherein one end of said secondary winding (L_{S}) is connected to a second inductor (L₂), with the other end of said second inductor (L₂) being connected to said Josephson junction (J₁), and the other end of said secondary winding (L_{S}) being connected to ground (12).

5. The circuit according to claim 2, further comprising:
a first Josephson junction (J₁) and a second Josephson junction (J₂) each having first and second terminals;
a first inductor (L₁) and a second inductor (L₂) defining input inductors; and
first and second inputs (A, B) for receiving input pulses (A, B) connected to one end of respective ones of said input inductors (L₁, L₂), said input pulses including positive (75, 80) and negative portions (75', 80'); wherein
the second ends of said first and second inductors (L₁, L₂) is commonly connected to a terminal of said first Josephson junction (J₁);
the other terminal of said first Josephson junction (J₁) is connected to a terminal of said second Josephson junction (J₂);
one end of said secondary winding (L_{S}) is connected to a third inductor (L₃), with the other end of said third inductor (L₃) being connected to said terminal of said second Josephson junction (J₂); and
said circuit forms an Exclusive OR gate.

6. The circuit according to claim 1, further comprising:
a Josephson junction (J₁) having a first terminal and a second terminal;
a first inductor (L₁) and a second inductor (L₂) defining input inductors;
a first input (A) and a second input (B) for receiving input pulses connected to one end of respective ones of said first and second inductors;
wherein
the second ends of said first and second inductors are connected to one of the first terminal or the second terminal of said Josephson junction; and
an output (Q) is connected to said terminal of said Josephson junction (J₁), with said circuit forming an AND gate.

7. The circuit according to claim 2, further comprising:
first and second Josephson junctions (J₁, J₂) each having a first terminal and a second terminal;
a first inductor (L₁) and a second inductor (L₂) defining input inductors;
a third inductor (L₃) inductively coupled to said second inductor (L₂);
said first inductor (L₁) being connected to a first terminal of said second Josephson junction (J₂);
said second inductor (L₂) being connected to said first terminal of said first Josephson junction (J₁);
a fourth inductor (L₄) connected between one end of said secondary winding (L_{S}) and said first terminal of said first Josephson junction (J₁);
said third inductor (L₃) being connected to the junction between said first Josephson junction (J₁) and said second Josephson junctions (J₂), with said circuit forming an OR gate.

## Patentansprüche

1. Eine supraleitende Einzelflussquanten-Schaltung, aufweisend:
mindestens einen Josephson-Kontakt (J₁) zum Empfangen eines Eingangspulses (A), wobei der Josephson-Kontakt (J₁) dazu eingerichtet ist, sich umzukehren, wenn der Strom durch den Josephson-Kontakt (J₁) einen kritischen Wert übersteigt, und
ein Bias-Transformator (20) zum Empfangen einer AC-Wellenform (22), wobei der Bias-Transformator eine primäre Wicklung (Lₚ) und eine sekundäre Wicklung (Lₛ) aufweist, wobei die sekundäre Wicklung (Lₛ) mit dem Josephson-Kontakt (J₁) verbunden ist zum Zuführen eines aus der Wellenform abgeleiteten Bias-Stroms daran,
**gekennzeichnet dadurch, dass**
der Eingangspuls (A) einen positiven Abschnitt (36, 75, 92) gefolgt durch einen negativen Abschnitt (36', 75', 92') aufweist und die Schaltung eingerichtet ist, so dass der negative Abschnitt (36', 75', 92') des Eingangspulses (A) die Schaltung für einen nachfolgenden Eingangspuls zurücksetzt.

2. Die Schaltung gemäß Anspruch 1, ferner aufweisend:
mindestens einen Eingang (A) zum Zuführen des Eingangspulses (A) durch eine erste Induktivität (L₁) an den Josephson-Kontakt (J₁), und
einen Ausgang (Q) zum Ableiten eines Ausgangspulses von dem Josephson-Kontakt.

3. Die Schaltung gemäß Anspruch 2, wobei die AC-Wellenform (22) eine trapezförmige Wellenform definiert.

4. Die Schaltung gemäß Anspruch 2, wobei ein Ende der sekundären Wicklung (Lₛ) mit einer zweiten Induktivität (L₂) verbunden ist, wobei das andere Ende der zweiten Induktivität (L₂) mit dem Josephson-Kontakt (J₁) verbunden ist, und das andere Ende der sekundären Wicklung (Lₛ) mit Masse (12) verbunden ist.

5. Die Schaltung gemäß Anspruch 2, ferner aufweisend:
einen ersten Josephson-Kontakt (J₁) und einen zweiten Josephson-Kontakt (J₂), von welchen jeder einen ersten und einen zweiten Anschluss aufweist,
eine erste Induktivität (L₁) und eine zweite Induktivität (L₂), welche Eingangsinduktivitäten definieren, und
einen ersten und einen zweiten Eingang (A, B) zum Empfangen von Eingangspulsen (A, B), welche mit einem Ende einer jeweiligen der Eingangsinduktivitäten (L₁, L₂) verbunden sind, wobei die Eingangspulse positive (75, 80) und negative Abschnitte (75', 80') aufweisen, wobei
die zweiten Enden der ersten und der zweiten Induktivität (L₁, L₂) gemeinsam mit einem Anschluss des ersten Josephson-Kontakts (J₁) verbunden sind,
der andere Anschluss des ersten Josephson-Kontakts (J₁) mit einem Anschluss des zweiten Josephson-Kontakts (J₂) verbunden ist,
ein Ende der sekundären Wicklung (Lₛ) mit einer dritten Induktivität (L₃) verbunden ist, wobei das andere Ende der dritten Induktivität (L₃) mit besagtem Anschluss des zweiten Josephson-Kontakts (J₂) verbunden ist, und
die Schaltung ein Exklusives-ODER-Gatter bildet.

6. Die Schaltung gemäß Anspruch 1, ferner aufweisend:
einen Josephson-Kontakt (J₁) mit einem ersten Anschluss und einem zweiten Anschluss,
eine erste Induktivität (L₁) und eine zweite Induktivität (L₂), welche Eingangsinduktivitäten definieren,
einen ersten Eingang (A) und einen zweiten Eingang (B) zum Empfangen von Eingangspulsen, welche mit einem Ende einer jeweiligen der ersten und der zweiten Induktivität (L₁, L₂) verbunden sind,
wobei
die zweiten Enden der ersten und der zweiten Induktivität mit einem von dem ersten Anschluss oder dem zweiten Anschluss des Josephson-Kontakts verbunden sind, und
ein Ausgang (Q) mit besagtem Anschluss des Josephson-Kontakts (J₁) verbunden ist, wobei die Schaltung ein UND-Gatter bildet.

7. Die Schaltung gemäß Anspruch 2, ferner aufweisend:
einen ersten und einen zweiten Josephson-Kontakt (J₁, J₂), von welchen jeder einen ersten Anschluss und einen zweiten Anschluss hat,
eine erste Induktivität (L₁) und eine zweite Induktivität (L₂), welche Eingangsinduktivitäten definieren,
eine dritte Induktivität (L₃), welche mit der zweiten Induktivität (L₂) induktiv gekoppelt ist,
wobei die erste Induktivität (L₁) mit einem ersten Anschluss des zweiten Josephson-Kontakts (J₂) verbunden ist,
wobei die zweite Induktivität (L₂) mit dem ersten Anschluss des ersten Josephson-Kontakts (J₁) verbunden ist,
eine vierte Induktivität (L₄), welche zwischen einem Ende der sekundären Wicklung (Lₛ) und dem ersten Anschluss des ersten Josephson-Kontakts (J₁) verbunden ist,
wobei die dritte Induktivität (L₃) mit der Verbindung zwischen dem ersten Josephson-Kontakt (J₁) und dem zweiten Josephson-Kontakt (J₂) verbunden ist, wobei die Schaltung ein ODER-Gatter bildet.

## Revendications

1. Circuit quantique à flux unique à supraconducteurs, comprenant :
au moins une jonction Josephson (J₁) destinée à recevoir une impulsion d'entrée (A), ladite jonction Josephson (J₁) étant configurée de façon à changer d'état lorsque le courant qui circule à travers ladite jonction Josephson (J₁) dépasse une valeur critique ; et
un transformateur de polarisation (20) destiné à recevoir une forme d'onde AC (22), ledit transformateur de polarisation présentant un enroulement primaire (L_{P}) et un enroulement secondaire (L_{S}), ledit enroulement secondaire étant connecté à ladite jonction Josephson (J₁) de façon à lui fournir un courant de polarisation obtenu à partir de ladite forme d'onde ;
**caractérisé par le fait que** :
ladite impulsion d'entrée (A) présente une partie positive (36, 75, 92) suivie d'une partie négative (36', 75', 92'), et le circuit est configuré de telle sorte que ladite partie négative (36', 75', 92') de ladite impulsion d'entrée (A) réinitialise le circuit pour une impulsion d'entrée ultérieure.

2. Circuit selon la revendication 1, comprenant en outre :
au moins une entrée (A) destinée à fournir l'impulsion d'entrée (A) par l'intermédiaire d'un premier inducteur (L₁) à ladite jonction Josephson (J₁) ; et
une sortie (Q) destinée à obtenir une impulsion de sortie à partir de ladite jonction Josephson.

3. Circuit selon la revendication 2, dans lequel ladite forme d'onde AC (22) définit une forme d'onde trapézoïdale.

4. Circuit selon la revendication 2, dans lequel une extrémité dudit enroulement secondaire (L_{S}) est connectée à un deuxième inducteur (L₂), l'autre extrémité dudit deuxième inducteur (L₂) étant connectée à ladite jonction Josephson (J₁), et l'autre extrémité dudit enroulement secondaire (L_{S}) étant connectée à la masse (12).

5. Circuit selon la revendication 2, comprenant en outre :
une première jonction Josephson (J₁) et une seconde jonction Josephson (J₂), chacun d'elles présentant des première et deuxième bornes ;
un premier inducteur (L₁) et un deuxième inducteur (L₂) qui définissent des inducteurs d'entrée ; et
des première et seconde entrées (A, B) destinées à recevoir des impulsions d'entrée (A, B) connectées à une extrémité de ceux respectifs desdits inducteurs d'entrée (L₁, L₂), lesdites impulsions d'entrée comprenant des parties positives (75 et 80) et des parties négatives (75', 80') ; dans lequel :
les secondes extrémités desdits premier et deuxième inducteurs (L₁, L₂) sont connectées de manière commune à une borne de ladite première jonction Josephson (J₁) ;
l'autre borne de ladite première jonction Josephson (J₁) est connectée à une borne de ladite seconde jonction Josephson (J₂) ;
une extrémité dudit enroulement secondaire (L_{S}) est connectée à un troisième inducteur (L₃), l'autre extrémité dudit troisième inducteur (L₃) étant connectée à ladite borne de ladite deuxième jonction Josephson (J₂) ; et
ledit circuit forme une porte OR exclusif.

6. Circuit selon la revendication 1, comprenant en outre :
une jonction Josephson (J₁) qui présente une première borne et une seconde borne ;
un premier inducteur (L₁) et un deuxième inducteur (L₂) qui définissent des inducteurs d'entrée ;
une première entrée (A) et une seconde entrée (B) destinées à recevoir des impulsions d'entrée connectées à une extrémité desdits premier et deuxièmes inducteurs respectifs ;
dans lequel :
les secondes extrémités desdits premier et deuxième inducteurs sont connectées à l'une de la première borne ou de la seconde borne de ladite jonction Josephson dite ; et
une sortie (Q) est connectée à ladite borne de ladite jonction Josephson (J₁), avec ledit circuit formant une porte AND.

7. Circuit selon la revendication 2, comprenant en outre :
des première et seconde jonctions Josephson (J₁, J₂) chacune d'elles présentant une première borne et une seconde borne ;
un premier inducteur (L₁) et un deuxième inducteur (L₂) qui définissent des inducteurs d'entrée ;
un troisième inducteur (L₃) couplé de manière inductive audit deuxième inducteur (L₂) ;
ledit premier inducteur (L₁) étant connecté à une première borne de ladite seconde jonction Josephson (J₂) ;
ledit deuxième inducteur (L2) étant connecté à ladite première borne de ladite première jonction Josephson (J₁) ;
un quatrième inducteur (L₄) connecté entre une extrémité dudit enroulement secondaire (L_{S}) et ladite première borne de ladite première jonction Josephson (J₁) ;
ledit troisième inducteur (L₃) étant connecté à la jonction entre ladite première jonction Josephson (J₁) et ladite seconde jonction Josephson (J₂), ledit circuit formant une porte OR.
